Europäisches Patentamt

European Patent Office

Office européen des brevets

(11) Veröffentlichungsnummer: **0 135 024**
**B1**

(12) **EUROPÄISCHE PATENTSCHRIFT**

(45) Veröffentlichungstag der Patentschrift:
27.09.89

(51) Int. Cl.⁴: **H 03 H 17/02**, H 03 G 3/00

(21) Anmeldenummer: 84108368.6

(22) Anmeldetag: 17.07.84

(54) Übertragungsanordnung für digitale Signale.

(30) Priorität: 15.09.83 DE 3333274

(43) Veröffentlichungstag der Anmeldung:
27.03.85 Patentblatt 85/13

(45) Bekanntmachung des Hinweises auf die Patenterteilung:
27.09.89 Patentblatt 89/39

(84) Benannte Vertragsstaaten:
AT DE FR GB NL

(56) Entgegenhaltungen:
DE-A- 2 840 471

IEEE TRANSACTIONS ON CIRCUITS AND SYSTEMS,
Band CAS-24, Nr. 5, Mai 1977, Seiten 277-279, IEEE, New
York, US; H. SCHRÖDER: "High word-rate digital filters
with programmable table look-up"
PROCEEDINGS OF EUSIPCO-80, FIRST EUROPEAN
SIGNAL PROCESSING CONFERENCE, Lausanne,
16.-18. September 1980, Seiten 123-129, North-Holland
Publishing Co., Amsterdam, NL: "Implementation of
variable digital filters"
PATENTS ABSTRACTS OF JAPAN, Band 9, Nr. 69
(E-305)[1792], 29. März 1985; & JP - A - 59 207 720
(TOSHIBA K.K.) 24-11-1984

(73) Patentinhaber: ANT Nachrichtentechnik GmbH,
Gerberstrasse 33, D-7150 Backnang (DE)

(72) Erfinder: Göckler, Heinz, Dipl.-Ing., Elbinger Strasse 52,
D-7150 Backnang (DE)

(74) Vertreter: Wiechmann, Manfred, Dipl.-Ing., ANT
Nachrichtentechnik GmbH
Gerberstrasse 33 Postfach 11 20, D-7150 Backnang (DE)

## Beschreibung

Die Erfindung betrifft eine Übertragungsanordnung für digitale Signale, deren Übertragungsfunktion ohne Betriebsunterbrechung mit Hilfe von Umschaltmitteln verändert werden kann. Eine solche Übertragungsanordnung ist bei der digitalen Filterung allgemein, aber auch bei der Pegelstellung anwendbar, wobei ein Koeffizientensatz, beispielsweise ein Satz von Filterparametern während des Betriebes umschaltbar sein soll. Als digitale Signale kommen Sprach-, Musik-, aber auch nicht hörbare Signale in Betracht.

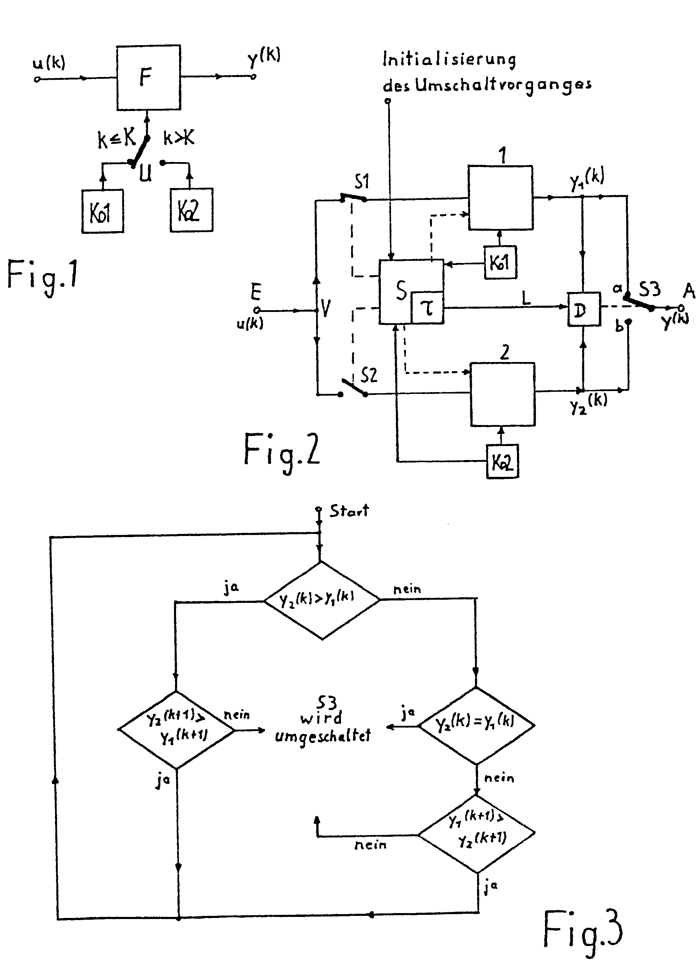

Die einfachste Methode, die Übertragungsfunktion einer Übertragungsanordnung für digitale Signale im Betrieb zu ändern, besteht darin, zwischen zwei Abtastzeitpunkten k und k+1 den gesamten Koeffizientensatz auszutauschen. Figur 1 veranschaulicht dies in einer schematischen Darstellung: Das digitale Eingangssignal u(k) durchläuft ein als Übertragungsglied in einer Übertragungsanordnung vorgesehenes Filter F, an dessen Ausgang das digitale Ausgangssignal y(k) erscheint. Das Filter ist über einen Umschalter U wahlweise mit einem Koeffizientensatz Ko1 bzw. Ko2 verbindbar. Anfangs, nämlich bis zu einer beabsichtigten Veränderung der Übertragungsfunktion des Filters F wird der Koeffizientensatz Ko1 verwendet. Dies gilt für alle Abtastzeitpunkte k bis zu dem Abtastzeitpunkt K unmittelbar vor der Koeffizentenumschaltung durch den Umschalter U. Wird die Anzahl der Abtastzeitpunkte k größer als K, so wird über den Umschalter U der Koeffizentensatz Ko2 benutzt. Eine solche abrupte, momentane Umschaltung des Koeffizientensatzes führt ohne spezielle Maßnahmen für eine Störunterdrückung zu Störungen im Ausgangssignal y(k), und zwar – beispielsweise bei Audiosignalen – zu Störungen, die für das Gehör unangenehm sind. Es entstehen beispielsweise Knackgeräusche, die je nach vorliegender Konfiguration und zufälliger Wahl des Umschaltzeitpunktes mehr oder weniger unangenehm in Erscheinung treten.

Es ist denkbar, solche Störungen durch Einschalten von Störunterdrückungsgliedern in den Weg für die digitalen Signale zu reduzieren. Solche Lösungen haben sich aber als nicht voll befriedigend erwiesen, da dadurch auch das Nutzsignal in einer unerwünschten Weise beeinflußt wird.

Demzufolge ist es Aufgabe der vorliegenden Erfindung eine Übertragungsanordnung für digitale Signale anzugeben, bei welcher die beschriebenen Störungen nicht unterdrückt, sondern weitestgehend vermieden werden.

Diese Aufgabe wird gelöst durch die Übertragungsanordnung mit den Merkmalen des Patentanspruchs 1. Vorteilhafte Weiterbildungen sind in den Unteransprüchen angegeben.

Der Erfindung liegen folgende Überlegungen zugrunde: Systemtheoretisch beginnt bei der Koeffizientenumschaltung nach Figur 1 ab dem Abtastzeitpunkt K+1 mit dem neuen Koeffizientensatz Ko2 ein Filtereinschwingvorgang, der mit dem Anfangszustand der Filterzustandsvariablen nach dem Zeitpunkt K startet. Aus diesem Grund ist der Einschwingvorgang, der mehr oder weniger stark in Erscheinung tretende Störungen des zu filternden digitalen Signales u(k) hervorruft, vom Zustand $\underline{x}$(k) des Filters F während der Umschaltung abhängig. (Mit $\underline{x}$(k) wird von der gebräuchlichen Zustandsdarstellung digitaler Filter Gebrauch gemacht, siehe z. B. H. W. Schüßler: «Digitale Systeme zur Signalverarbeitung», Springer Verlag, 1973, Kapitel 2). Mit Hilfe der folgenden Zustandsdarstellung läßt sich der Zusammenhang zwischen dem Filtereingangssignal u(k) und dem Filterausgangssignal y(k) angeben:

$$\underline{x}(k+1) = \underline{A}\,\underline{x}(k) + \underline{b}\,u(k) \qquad (1\,a)$$
$$y(k) = \underline{c}^T\,\underline{x}(k) + d\,u(k) \qquad (1\,b)$$

Dabei ist $\underline{A}$ die Zustandsübergangsmatrix (NxN-Matrix, wobei N der Filtergrad ist), $\underline{b}$ der Eingangsvektor und $\underline{c}^T$ der transponierte Ausgangsvektor (Dimension $\underline{N}$). d ist eine skalare Konstante.

Diese Zustandsdarstellung zeigt, daß offenbar der Filterzustand $\underline{x}$(k) mit dem Vektor $\underline{c}^T$ an den Filterausgang übertragen wird. $\underline{c}^T$ ist skalierungsabhängig. Das Eingangssignal $\overline{u}$(k) wirkt über die skalare Konstante d auf den Ausgang. Diese Konstante d ist aber skalierungsinvariant. Aufgrund der Gleichungen 1a und b bestehen also folgende Abhängigkeiten des Einschwingvorganges bei der Koeffizientenumschaltung:

a) Vom Umschaltzeitpunkt to (der zwischen den Abtastzeitpunkten K und K+1 liegt) sind abhängig:

der Filterzustand $\underline{x}$(k),
das Filtereingangssignal u(k) und
das Filterausgangssignal y(k).

Es gibt nun Fälle, wo die Umschaltung dann am wenigsten störend ist, wenn der Betrag des Vektors $\underline{x}$ zum Umschaltzeitpunkt to, also der Betrag von $\underline{x}_o$, also

$$\|\underline{x}_o\|_2 = \sqrt{\underline{x}_o^T\,\underline{x}_o}$$

minimal ist,

wobei $\underline{x}_o$ = $\underline{x}$(K) der Zustand des Filters unmittelbar vor der Koeffizientenumschaltung ist.

Abweichend davon kann es aber günstig sein, das Filter dann umzuschalten, wenn entweder das Filtereingangssignal oder das Filterausgangssignal durch Null geht.

Dies zeigt, daß es kein eindeutiges Umschaltkriterium für eine störungsfreie, abrupte Koeffizientenänderung gibt.

b) Auch von der Filterskalierung abhängend haben sich die bei plötzlicher Koeffizientenumschaltung auftretenden Störungen erwiesen. Es hat sich aber auch gezeigt, daß eine Skalierung, die sich bezüglich der auftretenden Störungen bei Umschaltung der Filterkoeffizienten in einem bestimmten Punkt des Signalverlaufs als besonders günstig erwiesen hat, bei Umschaltung in einem anderen Punkt zu größeren Störungen führt, als eine Skalierung, die bei Umschaltung im ersten Punkt zu größeren Störungen führte.

Es gibt also auch bezüglich der Filterskalierung kein eindeutiges Kriterium für die störungsfreie oder -arme Umschaltung eines Digitalfilters im Betrieb.

Aus diesem Grund wird mit der Erfindung ein neuer Weg beschritten, der anhand von Figur 2 näher erläutert wird:

Dort ist zunächst wie in Figur 1 zwischen dem Eingang E und dem Ausgang A für die digitalen Signale ein Übertragungsglied 1 (mit zugeordnetem Koeffizientensatz Ko1) vorgesehen. Dessen Ausgangsgröße $y_1(k)$ gelangt über Umschaltmittel S3 zum Ausgang A.

Ausgehend von einer Verzweigung V am Eingang E ist nun aber parallel zu dem das Übertragungsglied 1 enthaltenden Zweig ein zweiter Zweig mit einem zweiten digitalen Übertragungsglied 2 vorgesehen, welchem der Koeffizientensatz Ko2 zugeordnet ist. Die Ausgangsgröße $y_2(k)$ gelangt bei entsprechender Stellung der Umschaltmittel S3 anstelle der Ausgangsgröße $y_1(k)$ zum Ausgang A.

Die Umschaltmittel S3 sind von einem Diskriminator D gesteuert, welcher die Ausgangsgrößen $Y_1$ und $y_2$ miteinander vergleicht. Den Übertragungsgliedern 1 und 2 sind jeweils (unter Umständen entbehrliche) Schalter S1 bzw. S2 vorgeschaltet, die von einer Steuereinrichtung S steuerbar sind.

Wird nun bei zunächst geschlossenem Schalter S1 und den in der dargestellten Stellung befindlichen Umschaltmitteln S3 eine Veränderung der Übertragungsfunktion der gezeigten Übertragungsanordnung gewünscht, so werden statt einer Änderung der Koeffizienten des ersten Übertragungsgliedes 1 die Koeffizienten des zweiten Übertragungsgliedes 2 auf die gewünschten Werte umgeschaltet. Die Ausgangsgröße $y_2$ des zweiten Übertragungsgliedes 2 wird aber über die Umschaltmittel S3 erst dann an den Ausgang A der Übertragungsanordnung weitergeleitet, wenn der Diskriminator D, der um die Einschwingzeit des zweiten Übertragungsgliedes 2 verzögert wirksam geschaltet wird, nach einem Vergleich der Ausgangsgrößen $y_1$ und $y_2$ der beiden Übertragungsglieder die Umschaltung der Umschaltmittel S3 bewirkt.

Die Funktion kann also im einzelnen folgendermaßen beschrieben werden: Anfangs ist bei geschlossenem Schalter S1 und in der gezeigten Stellung a der Umschaltmittel S3 das Übertragungsglied 1 in Betrieb mit dem Koeffizientensatz Ko1. Ist nun eine Umschaltung auf einen anderen Koeffizientensatz beabsichtigt, so wird dieser als Koeffizientensatz Ko2 durch entsprechende Einspeicherung dem Übertragungsglied 2 zugeordnet und der Schalter S2 zu einem Abtastzeitpunkt K1 geschlossen. Damit ist das Übertragungsglied 2 in Betrieb genommen, ohne daß aber dessen Ausgangsgröße $y_2$ an den Ausgang A gelangt. Dies geschieht vielmehr erst zu einem späteren Zeitpunkt, gesteuert durch den Diskriminator D, der die Umschaltmittel S3 von der Stellung a in die Stellung b steuert; damit wird anstelle der Ausgangsgröße $y_1(k)$ die Ausgangsgröße $y_2(k)$ des Übertragungsgliedes 2 an den Ausgang A geschaltet, und zwar zu einem Zeitpunkt K3, der später als K1 liegt. Nach dem Zeitpunkt K3 verbleibt das Umschaltmittel S3 in der Stellung b. Mindestens bis zu diesem Zeitpunkt K3 bleibt auch der Schalter S1 geschlossen. Danach kann er geöffnet werden, so daß nun ein Zustand erreicht ist, bei dem gegenüber dem Ausgangszustand die Rolle der Übertragungsglieder 1 und 2 miteinander vertauscht ist.

Zwischen dem Zeitpunkt K1, in welchem der Schalter S2 geschlossen wurde und dem Umschaltzeitpunkt K3 der Umschaltmittel S3 konnte das Übertragungsglied 2 einschwingen. Hierzu wurde mindestens der Zeitraum bis zu einem Zeitpunkt K2 (der vor K3 liegt) benötigt. Die für den Einschwingvorgang des Übertragungsgliedes 2 benötigte Verzögerungzeit beträgt $\tau = K2 - K1$. Vor Ablauf dieser Verzögerungszeit wurde der Diskriminator D nicht wirksam. Danach allerdings wurden die beiden Ausgangsgrößen $y_1(k)$ und $y_2(k)$ solange verglichen, bis sie übereinstimmten oder ihre Differenz das Vorzeichen wechselte. Als dies zum Zeitpunkt K3 geschah, erfolgte die Umschaltung der Umschaltmittel S3, so daß dann die Ausgangsgröße $y_2(k)$ das Ausgangssignal $y(k)$ bildete.

Die Bestimmung des Umschaltzeitpunktes K3 kann über die Auswertung des Vorzeichens der Differenz $y_2(k) - y_1(k)$ erfolgen oder mittels maximal dreier sequentieller Abfragen z. B. entsprechend Figur 3.

Die Anwendung der Übertragungsanordnung nach der Erfindung führt zu einer störungsarmen oder -freien Umschaltung der Übertragungsfunktion. Die Verzögerungszeit $\tau = K2 - K1$ zum Einschwingen des jeweils neu einzuschaltenden Übertragungsgliedes 2 oder 1 kann beispielsweise folgendermaßen bemessen sein: Hat die Übertragungsfunktion des Übertragungsgliedes 2 Glockenform mit einer Mittenfrequenz von 4 kHz, so kann die Einschwingzeit des Übertragungsgliedes 2 bei Anwendung für Tonfrequenzen ca. 50 Abtastwerte entsprechend einer Millisekunde betragen; hat die Übertragungsfunktion des Übertragungsgliedes 2 Glockengestalt mit einer Mittenfrequenz von 40 Hz, so kommen als Verzögerungszeit zum Einschwingen ca. 5000 Abtastwerte entsprechend 100 Millisekunden in Betracht.

Es ist möglich, das um die Verzögerungszeit $\tau$ verzögerte Wirksamschalten des Diskriminators D in Abhängigkeit von dem die Einschwingzeit bestimmenden Koeffizientensatz Ko2 automatisch zu steuern, beispielsweise mit Hilfe einer Steuereinrichtung S, die über eine Leitung L verzögert um die Verzögerungszeit $\tau$ auf den Diskriminator D einwirkt und auch den Schalter S1 erst nach Umschaltung der Umschaltmittel S3 öffnet. Die Wirkung, welche das Öffnen und Schließen der Schalter S1 und S2 hat, kann auch erzielt werden durch Außerbetrieb- bzw. Inbetriebnehmen der Übertragungsanordnung 1 bzw. 2.

**Patentansprüche**

1. Übertragungsanordnung für digitale Signale, deren Übertragungsfunktion ohne Betriebsunterbrechung mit Hilfe von Umschaltmitteln verändert werden kann, dadurch gekennzeichnet,

a) daß ausgehend von einer Verzweigung (V) zwei Zweige jeweils mit einem digitalen Übertragungsglied (1, 2) vorgesehen sind, wobei den Übertragungsgliedern unterschiedliche Übertragungscharakteristiken gegeben werden können,

b) daß die Zweige ausgangsseitig über die Umschaltmittel (S3) wahlweise mit dem Ausgang (A) der Übertragungsanordnung verbindbar sind und

c) daß die Umschaltmittel (S3) von einem Diskriminator (D) steuerbar sind, der zum Verändern der Übertragungsfunktion nach Ablauf einer Verzögerungszeit ($\tau$) wirksam geschaltet wird und die Umschaltmittel (S3) betätigt, wenn die Differenz zwischen den Ausgangsgrößen ($y_1$, $y_2$) der Übertragungsglieder einen vorgegebenen Wert betragsmäßig unterschreitet, insbesondere Null wird, oder das Vorzeichen wechselt.

2. Übertragungsanordnung nach Anspruch 1, dadurch gekennzeichnet, daß gesteuert von einer Steuereinrichtung (S) nur ein digitales Übertragungsglied (1) in Betrieb ist, solange keine Änderung der Übertragungsfunktion beabsichtigt ist, während bei beabsichtigter Änderung die Steuereinrichtung (S) zur Inbetriebnahme des anderen Übertragungsgliedes (2), zum Wirksamschalten des Diskriminators (D) und zum Außerbetriebsetzen (Abschalten) des ersten Übertragungsgliedes (1) nach dem Umschalten der Umschaltmittel (S3) vorgesehen ist.

3. Übertragungsanordnung nach Anspruch 1 oder 2, dadurch gekennzeichnet, daß gesteuert von einer Steuereinrichtung (S) zwei Schalter (S1, S2) vorgesehen sind, von denen in jedem Zweig dem betreffenden Übertragungsglied (1, 2) ein Schalter vorgeschaltet ist und von denen nur einer (S1) geschlossen ist, solange keine Änderung der Übertragungsfunktion beabsichtigt ist, während bei beabsichtigter Änderung die Steuereinrichtung (S) zum Schließen des anderen Schalters (S2), zum Wirksamschalten des Diskriminators (D) und zum Öffnen des ersten Schalters (S1) nach dem Umschalten der Umschaltmittel (S3) vorgesehen ist.

4. Übertragungsanordnung nach Anspruch 1, dadurch gekennzeichnet, daß die Verzögerungszeit ($\tau$) für das Wirksamschalten des Diskriminators (D) so bemessen ist, daß das während der Verzögerungszeit ($\tau$) nicht mit dem Ausgang (A) verbundene Übertragungsglied (2) Zeit zum Einschwingen hat.

5. Übertragungsanordnung nach Anspruch 4, dadurch gekennzeichnet, daß die Verzögerungszeit konstant mindestens so groß gewählt ist wie die größte vorkommende Einschwingzeit.

6. Übertragungsanordnung nach Anspruch 4, dadurch gekennzeichnet, daß die Verzögerungszeit automatisch der Einschwingzeit des vor der Umschaltung nicht mit dem Ausgang (A) verbundenen Übertragungsgliedes (2) angepaßt ist.

7. Übertragungsanordnung nach einem der vorangehenden Ansprüche, dadurch gekennzeichnet, daß der Diskriminator (S) ausgebildet ist zur Durchführung eines Prüfzyklus, innerhalb dessen die im folgenden als erste bezeichnete Ausgangsgröße ($y_1$) des anfangs mit dem Ausgang (A) der Übertragungsanordnung verbundenen Übertragungsgliedes (1) mit der zweiten Ausgangsgröße ($y_2$) verglichen wird und

a) der wieder von vorne beginnt, wenn bei zwei aufeinanderfolgenden Prüfzeitpunkten (k, k + 1) die erste Ausgangsgröße ($y_1$) entweder kleiner oder größer als die zweite ($y_2$) bleibt, oder

b) welcher die Umschaltung bewirkt, wenn

b1) die Ausgangsgrößen anfangs (k) untereinander gleich oder

b2) eine Ausgangsgröße anfangs (k) größer, darauffolgend (k + 1) jedoch kleiner als die andere ist.

**Claims**

1. Transmission arrangement for digital signals, the transfer function of which can be changed with the aid of change-over switch means without interruption of operation, characterised thereby,

a) that two branches starting out from a branching point (V) are each provided with a respective digital transmission member (1, 2), wherein different transmission characteristics can be given to the transmission member,

b) that the branches are connectable at the output by way of the change-over switch means (S3) selectably with the output (A) of the transmission arrangement and

c) that the change-over switch means (S3) are controllable by a discriminator (D), which for the changing of the transfer function is switched to be effective after run-down of a delay time ($\tau$) and actuates the change-over switch means (S3) when the difference between the output magnitudes ($y_1$, $y_2$) of the transmission member falls in amount below a preset value, in particular becomes zero, or changes its sign.

2. Transmission arrangement according to claim 1, characterised thereby, that under the control of a control equipment (S), only one digital transmission member (1) is in operation as long as no change in the transfer function is intended, whilst the control equipment (S) is provided in the case of an intended change for putting the other transmission member (2) into operation, for switching the discriminator (D) to be effective and for putting (switching off) the first transmission member (1) out of operation after the switching-over of the change-over switch means (S3).

3. Transmission arrangement according to claim 1 or 2, characterised thereby, that under the control of a control equipment (S), two switches (S1, S2) are provided, of which one switch in each branch is connected in front of the transmission member (1, 2) concerned and of which only one switch (S1) is closed as long as no change in the transfer function is intended, whilst the control equipment (S) is provided in the case of an intended change for the closing of the other switch (S2), for switching the discriminator (D) to be effective and for the opening of the first switch (S1) after the switching-over of the change-over switch means (S3).

4. Transmission arrangement according to claim 1, characterised thereby, that the delay time ($\tau$) for switching the discriminator (D) to be effective is so dimensioned that the transmission member (2) not connected with the output (A) has time for initial transients during the delay time ($\tau$).

5. Transmission arrangement according to claim 4, characterised thereby, that the delay time is constant and chosen to be at least as great as the greatest arising time for initial transients.

6. Transmission arrangement according to claim 4, characterised thereby, that the delay time is automatically adapted to the time for initial transients of the transmission member (2) not connected with the output (A) before the switching-over.

7. Transmission arrangement according to one of the preceding claims, characterised thereby, that the discriminator (D) is constructed for the performance of a test cycle, within which the output magnitude ($y_1$), designated in the following as first, of the transmission member (1) initially connected with the output (A) of the transmission arrangement is compared with the second output magnitude ($y_2$) and

a) which starts again from the beginning when the first output magnitude ($y_1$) remains either smaller or greater than the second ($y_2$) at two successive test time points k, k + 1) or

b) which effects the switching-over when

b1) the output magnitudes are initially (k) each equal to the other or

b2) one output magnitude is initially (k) greater, thereupon (k + 1) however smaller than the other.

## Revendications

1. Agencement de transmission pour signaux numériques, dont la fonction de transfert peut, sans interruption d'exploitation, être modifiée à l'aide de moyens de commutation, caractérisé

a) par le fait que, partant d'une bifurcation (V), deux branches avec élément de transmission numérique (1, 2) sont prévues, des caractéristiques de transmission différentes pouvant être conférées aux éléments de transmission,

b) par le fait que les deux branches peuvent être reliées, côté sortie, par les moyens de commutation (S3), sélectivement à la sortie (A) de l'agencement de transmission, et

c) par le fait que les moyens de commutation (S3) peuvent être commandés par un discriminateur (D) qui, pour modifier la fonction de transfert, est validé après l'écoulement d'un temps de retard ($\tau$) et actionne alors les moyens de commutation (S3) si la différence entre les grandeurs de sortie ($y_1$, $y_2$) des éléments de transmission est, quant à sa valeur absolue, inférieure à une valeur prédéterminée, en particulier est nulle, ou change de signe.

2. Agencement de transmission selon revendication 1, caractérisé par le fait que, sous la commande d'un dispositif de commande (S), seul un élément de transmission numérique (1) est en fonctionnement, aussi longtemps qu'aucune modification de la fonction de transfert n'est envisagée, tandis qu'en cas de modification envisagée, le dispositif de commande (S) est prévu pour mettre en fonctionnement l'autre élément de transmission (2), pour valider le discriminateur (D) et pour mettre hors-fonctionnement (hors-circuit) le premier élément de transmission (1) après la commutation des moyens de commutation (S3).

3. Agencement de transmission selon revendication 1 ou 2, caractérisé par le fait qu'à la commande d'un dispositif de commande (S) sont subordonnés deux interrupteurs (S1, S2), chaque branche comportant l'un d'eux, en amont de l'élément de transmission correspondant (1, 2), et un seul (S1) d'entre eux étant fermé tant qu'aucune modification de la fonction de transfert n'est envisagée, tandis qu'en cas de modification envisagée le dispositif de commande (S) est prévu de façon à fermer l'autre interrupteur (S2), à valider le discriminateur (D) et à ouvrir le premier interrupteur (S1) après la commutation des moyens de commutation (S3).

4. Agencement de transmission selon revendication 1, caractérisé par le fait que le temps de retard ($\tau$) pour la validation du discriminateur (D) est d'une valeur telle que, pendant ce temps de retard ($\tau$), l'élément de transmission (2) relié à la sortie (A) ait le temps de passer par son régime transitoire.

5. Agencement de transmission selon revendication 4, caractérisé par le fait que le temps de retard constant est choisi au moins aussi grand que le plus long temps de régime transitoire intervenant.

6. Agencement de transmission selon revendication 4, caractérisé par le fait que le temps de retard est automatiquement adapté au temps de régime transitoire de l'élément de transmission (2) non relié à la sortie (A) avant la commutation.

7. Agencement de transmission selon l'une des revendications précédentes, caractérisé par le fait que le discriminateur (D) est conçu et réalisé pour exécuter un cycle de contrôle dans lequel la grandeur, ci-après appelée première grandeur de sortie ($y_1$) de l'élément de transmission (1) initialement relié à la sortie (A) de l'agencement de transmission est comparée à la deuxième grandeur de sortie ($y_2$), et

a) lequel recommence depuis le début si, pour deux instants de contrôle successifs (k, k + 1), la première grandeur de sortie ($y_1$) est soit plus petite, soit plus grande que la deuxième ($y_2$); ou

b) lequel provoque la commutation si

b1) les grandeurs de sortie au début (k) sont égales entre elles, ou

b2) une grandeur de sortie au début (k) est plus grande que l'autre, mais est plus petite la fois suivante (k + 1).

Fig.1

Fig.2

Fig.3